# EUROPEAN PATENT APPLICATION

(11) **EP 4 474 428 A1**
(43) Date of publication of application: **11.12.2024**
(21) Application number: 23746653.7
(22) Date of filing: 12.01.2023
(51) Int. Cl.: C08L 83/07, C08K 3/08, C08K 5/00, C08K 5/13, C08L 83/05

(54) **THERMALLY-CONDUCTIVE ADDITION-CURABLE SILICONE COMPOSITION AND CURED PRODUCT THEREOF**

(30) Priority: 31.01.2022 JP 2022012772
(71) Applicant: SHIN-ETSU CHEMICAL CO., LTD., Tokyo 1000005 (JP)
(72) Inventor: KITAZAWA, Keita, Annaka-shi, Gunma 379-0224 (JP); IKENO, Masayuki, Annaka-shi, Gunma 379-0224 (JP); HASEGAWA, Koji, Tokyo 100-0005 (JP); NONAKA, Shiori, Joetsu-shi, Niigata 942-8601 (JP)
(74) Representative: Sonnenhauser, Thomas Martin
(86) International application number: PCT/JP2023/000506
(87) International publication number: WO 2023/145438

(57) **Abstract**

The present invention is a thermal conductive addition-curable silicone composition including: an organopolysiloxane (A) having at least one aliphatic unsaturated hydrocarbon group in one molecule and having a kinematic viscosity at 25°C of 60 to 100,000 mm²/s; a phenol compound (B) at an amount of 0.01 to 10 mass% relative to an entirety of the composition; a silver powder (C) at an amount of 10 to 98 mass% relative to the entirety of the composition; an organohydrogenpolysiloxane (D) having two or more hydrogen atoms bonded to a silicon atom in one molecule at an effective amount sufficient for the composition to form a cured product; and a platinum-group metal catalyst (E) at an effective amount. This configuration provides a thermal conductive addition-curable silicone composition having excellent heat-dissipating ability.

## Description

### TECHNICAL FIELD

The present invention relates to a thermal conductive addition-curable silicone composition and a cured product thereof.

### BACKGROUND ART

Heat generation during operation and deterioration of performance due to the heat generation have been well known as common problems for electronic component packages and power modules. As a means for solving this problem, various heat dissipating technique have been used. Specifically, a typical technique is disposing a cooling member near a heat-generating portion and bringing them into close contact to efficiently remove heat from the cooling member.

In this case, a space between the heat-generating member and the cooling member lowers thermal conduction because of the presence of air, which is poor in heat conductivity, and thereby the temperature of the heat-generating member cannot be reduced sufficiently. To prevent the presence of such air and enhance heat conductivity, heat-dissipating materials having good heat conductivity and followability to the surface of the member, for example, heat-dissipating greases and heat-dissipating sheets, have been conventionally used (for example, Patent Documents 1 to 9).

As actual measures against the heat of electronic component packages and power modules, thinly compressible heat-dissipating greases and having excellent ability of filling a gap between the heat-generating portion and the cooling member are suitable from the viewpoint of heat-dissipating performance. Further, particularly useful is an addition-curable heat-dissipating grease in which heating and curing to a desired thickness after compression can prevent flow out (pump out) of the heat-dissipating grease caused by expansion and contraction due to thermal history of repeated heat generation and cooling of the heat-generating portion, which improves the reliability of the electronic component packages and the power modules (for example, Patent Document 10).

In recent years, there have been demands for furthermore increasing thermal conductivity of the heat-dissipating material in order to achieve high output and high performance of the electronic component packages and the power modules and to respond to new applications such as a semiconductor for an automatic driving vehicle and IoT. A thermal conductive addition-curable silicone composition that can satisfy these demands has been desired.

### CITATION LIST

### PATENT LITERATURE

Patent Document 1: JP 2002-327116 A
Patent Document 2: JP 2004-130646 A
Patent Document 3: JP 2009-234112 A
Patent Document 4: JP 2009-209230 A
Patent Document 5: JP 2010-095730 A
Patent Document 6: JP 2008-031336 A
Patent Document 7: JP 2007-177001 A
Patent Document 8: JP 2008-260798 A
Patent Document 9: JP 2009-209165 A
Patent Document 10: JP 2016-053140 A

### SUMMARY OF INVENTION

### TECHNICAL FIELD

Therefore, the present invention has been made in view of the above circumstances, and an object of the present invention is to provide a thermal conductive addition-curable silicone composition having excellent heat-dissipating ability.

### SOLUTION TO PROBLEM

To solve the above problem, the present invention provides a thermal conductive addition-curable silicone composition comprising:
an organopolysiloxane (A) having at least one aliphatic unsaturated hydrocarbon group in one molecule and having a kinematic viscosity at 25°C of 60 to 100,000 mm²/s;
a phenol compound (B) at an amount of 0.01 to 10 mass% relative to an entirety of the composition;
a silver powder (C) at an amount of 10 to 98 mass% relative to the entirety of the composition;
an organohydrogenpolysiloxane (D) having two or more hydrogen atoms bonded to a silicon atom in one molecule at an effective amount sufficient for the composition to form a cured product; and
a platinum-group metal catalyst (E) at an effective amount.

Such a thermal conductive addition-curable silicone composition has excellent heat-dissipating ability.

In the present invention, the component (B) is preferably a phenol compound represented by the following general formula (1A), 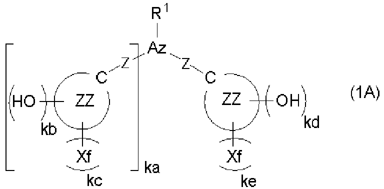 wherein R¹ represents a hydrogen atom, a halogen atom, a cyano group, or a hydroxy group; Az represents a linear, branched, or cyclic (ka+2)-valent hydrocarbon group or fluorinated hydrocarbon group having 1 to 20 carbon atoms, -CH₂- constituting the hydrocarbon group is optionally substituted with -O-, -C(=O)-, or - Si(R²R³)-, and R² and R³ represent a linear, branched, or cyclic alkyl group having 1 to 6 carbon atoms or a phenyl group; Xf each independently represents a hydrogen atom, a halogen atom, a linear, branched or cyclic monovalent hydrocarbon group having 1 to 10 carbon atoms and optionally substituted with a fluorine atom, an alkoxy group having 1 to 10 carbon atoms and optionally substituted with a fluorine atom, or an electron withdrawing group; Z represents a single bond or an oxygen atom; a ring ZZ each independently represents an aromatic monocyclic or polycyclic ring having 3 to 20 carbon atoms, and a carbon atom in the ring ZZ is optionally substituted with a nitrogen atom, an oxygen atom, or a sulfur atom; ka represents an integer of 0 to 2; kb and kd represent 1 or 2; and kc and ke represent an integer of 0 to 2.

Such a thermal conductive addition-curable silicone composition has more excellent heat-dissipating ability.

In the present invention, the component (B) is preferably a phenol compound represented by the following general formula (1B), 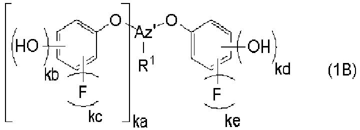 wherein Az' represents a linear, branched, or cyclic (ka+2)-valent hydrocarbon group or fluorinated hydrocarbon group having 1 to 19 carbon atoms, and -CH₂- constituting the hydrocarbon group is optionally substituted with -O-, -C(=O)-, or -Si(R²R³)-; ka represents 0 or 1; kb, kc, kd, and ke represent 1 or 2; and R¹, R², and R³ are same as above.

Such a thermal conductive addition-curable silicone composition more certainly has excellent heat-dissipating ability.

In the present invention, the component (C) preferably has an average particle diameter of 0.01 to 300 µm.

Such a thermal conductive addition-curable silicone composition yields a uniform composition having not excessively high viscosity to have excellent extensibility.

In the present invention, the thermal conductive addition-curable silicone composition preferably further comprises an effective amount of one or more addition-curing reaction controlling agents (F) selected from the group consisting of an acetylene compound, a nitrogen compound, an organophosphorus compound, an oxime compound, and an organochlorine compound.

Such a thermal conductive addition-curable silicone composition yields a desired sufficient shelf-life and pot-life, and causes no risk of deterioration of curability of the silicone composition.

The present invention provides a cured product of a thermal conductive addition-curable silicone having a thermal conductivity of 7.0 W/m·K or more, wherein the thermal conductivity is determined by:
sandwiching the aforementioned thermal conductive addition-curable silicone composition between two silicon plates having a diameter of 12.7 mm;
heating and curing the composition at 125°C for 1 hour in a state of applying a pressure of 0.14 MPa to produce a specimen for measuring thermal resistivity;
measuring a thermal resistivity value of the cured product of a thermal conductive addition-curable silicone by using a thermal conductivity measuring device;
measuring a thickness of the specimen with a micro-gauge;
calculating a thickness of the cured product of a thermal conductive addition-curable silicone with a difference from a thickness of the silicon plates measured in advance; and thereafter
deriving the thermal conductivity of the cured product of a thermal conductive addition-curable silicone by "the thickness (µm) of the cured product of a thermal conductive addition-curable silicone / the thermal resistivity value (mm²·K/W) of the cured product of a thermal conductive addition-curable silicone".

Such a cured product of a thermal conductive addition-curable silicone has excellent heat-dissipating ability.

### ADVANTAGEOUS EFFECTS OF INVENTION

The thermal conductive addition-curable silicone composition of the present invention has achieved high thermal conductivity by blending the phenol compound and the silver powder. As a result, mounting the composition on the electronic component package or the power module can exhibit excellent heat-dissipating performance.

### DESCRIPTION OF EMBODIMENTS

As noted above, there have been demands for development of the thermal conductive addition-curable silicone composition having excellent heat-dissipating ability.

The present inventors have made earnest study to achieve the above object, and consequently found that the thermal conductive addition-curable silicone composition having excellent heat-dissipating ability can be obtained by blending specific amounts of an aliphatic unsaturated hydrocarbon group-containing organopolysiloxane, a phenol compound, a silver powder, an organohydrogenpolysiloxane, and a platinum-group metal catalyst. This finding has led to completion of the present invention.

Specifically, the present invention is a thermal conductive addition-curable silicone composition comprising:
an organopolysiloxane (A) having at least one aliphatic unsaturated hydrocarbon group in one molecule and having a kinematic viscosity at 25°C of 60 to 100,000 mm²/s;
a phenol compound (B) at an amount of 0.01 to 10 mass% relative to an entirety of the composition;
a silver powder (C) at an amount of 10 to 98 mass% relative to the entirety of the composition;
an organohydrogenpolysiloxane (D) having two or more hydrogen atoms bonded to a silicon atom in one molecule at an effective amount sufficient for the composition to form a cured product; and
a platinum-group metal catalyst (E) at an effective amount.

Hereinafter, the present invention will be described in detail, but the present invention is not limited thereto.

### Thermal Conductive Addition-Curable Silicone Composition

The thermal conductive addition-curable silicone composition of the present invention contains components (A) to (E), described later, and additionally contains a component (F) and other components as necessary. Hereinafter, each component will be described in detail.

### Component (A)

The component (A) is an organopolysiloxane having at least 1, preferably 1 to 100, more preferably 2 to 50, aliphatic unsaturated hydrocarbon groups in one molecule and having a kinematic viscosity at 25°C of 60 to 100,000 mm²/s.

The aliphatic unsaturated hydrocarbon group is preferably a monovalent hydrocarbon group having an aliphatic unsaturated bond and having 2 to 8, further preferably 2 to 6, carbon atoms, and more preferably an alkenyl group. Examples thereof include alkenyl groups such as a vinyl group, an allyl group, a propenyl group, an isopropenyl group, a butenyl group, a hexenyl group, a cyclohexenyl group, and an octenyl group. The aliphatic unsaturated hydrocarbon group is particularly preferably a vinyl group. The aliphatic unsaturated hydrocarbon group may be bonded to any of a silicon atom at a terminal of the molecule chain or a silicon atom in a middle of the molecule chain, or may be bonded to both of them.

An organic group bonded to the silicon atom of the organopolysiloxane other than the aliphatic unsaturated hydrocarbon group is an unsubstituted or substituted monovalent hydrocarbon group having 1 to 18, preferably 1 to 10, and further preferably 1 to 8, carbon atoms. Examples thereof include: alkyl groups, such as a methyl group, an ethyl group, a propyl group, an isopropyl group, a butyl group, an isobutyl group, a tert-butyl group, a pentyl group, a neopentyl group, a hexyl group, a cyclohexyl group, an octyl group, a nonyl group, and a decyl group; aryl groups, such as a phenyl group, a tolyl group, a xylyl group, and a naphthyl group; aralkyl groups, such as a benzyl group, a phenethyl group, and a phenylpropyl group; or groups in which a part or all of hydrogen atoms in these groups are substituted with a halogen atom such as fluorine, bromine, and chlorine, cyano group, etc., for example, a chloromethyl group, a chloropropyl group, a bromoethyl group, a trifluoropropyl group, and a cyanoethyl group. The organic group is particularly preferably a methyl group or a trifluoropropyl group.

The organopolysiloxane has a kinematic viscosity at 25°C of 60 to 100,000 mm²/s, and preferably 100 to 30,000 mm²/s. The kinematic viscosity of less than 60 mm²/s deteriorates physical properties of the thermal conductive addition-curable silicone composition, and the kinematic viscosity of more than 100,000 mm²/s causes poor extensibility of the thermal conductive addition-curable silicone composition.

In the present invention, the kinematic viscosity refers to a value measured at 25°C with an Ubbelohde-type Ostwald viscometer (the same applies hereinafter).

A molecular structure of the organopolysiloxane is not particularly limited as long as the organopolysiloxane has the above properties, and examples thereof include a linear structure, a branched structure, a partially branched structure, or a linear structure having a cyclic structure. The organopolysiloxane particularly preferably has a linear structure in which the main chain is composed of repetition of a diorganosiloxane unit and both terminals of the molecule chain are blocked with a triorganosiloxy group. The organopolysiloxane having the linear structure may partially have a branched structure or a cyclic structure.

A blending amount of the component (A) is preferably 1.5 to 89 mass%, more preferably 1.7 to 50 mass%, and further preferably 2 to 20 mass% relative to an entirety of the composition. The blending mount of 89 mass% or less does not cause poor thermal conductivity, and the blending mount of 1.5 mass% or more does not unnecessarily increase the viscosity of the composition and does not deteriorate operability.

The organopolysiloxane may be used singly, or may be used in combination of two or more.

### Component (B)

The component (B) is a phenol compound, and blended as an additive for the thermal conductive addition-curable silicone composition. The phenol compound is preferably a phenol compound represented by the following general formula (1A). In the following description, some structures represented by the chemical formula may have enantiomers and diastereomers, and these isomers are representatively represented by one formula in such cases. These isomers may be used singly, or may be used as a mixture.

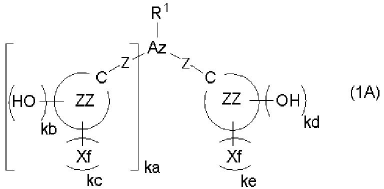

In the formula, R¹ represents a hydrogen atom, a halogen atom, a cyano group, or a hydroxy group; Az represents a linear, branched, or cyclic (ka+2)-valent hydrocarbon group or fluorinated hydrocarbon group having 1 to 20 carbon atoms, -CH₂- constituting the hydrocarbon group is optionally substituted with -O-, - C(=O)-, or -Si(R²R³)-, and R² and R³ represent a linear, branched, or cyclic alkyl group having 1 to 6 carbon atoms or a phenyl group; Xf each independently represents a hydrogen atom, a halogen atom, a linear, branched or cyclic monovalent hydrocarbon group having 1 to 10 carbon atoms and optionally substituted with a fluorine atom, an alkoxy group having 1 to 10 carbon atoms and optionally substituted with a fluorine atom, or an electron withdrawing group; Z represents a single bond or an oxygen atom; a ring ZZ each independently represents an aromatic monocyclic or polycyclic ring having 3 to 20 carbon atoms, and a carbon atom in the ring ZZ is optionally substituted with a nitrogen atom, an oxygen atom, or a sulfur atom; ka represents an integer of 0 to 2; kb and kd represent 1 or 2; and kc and ke represent an integer of 0 to 2.

Examples of the linear, branched, or cyclic (ka+2)-valent hydrocarbon group Az having 1 to 20 carbon atoms specifically include the following groups.

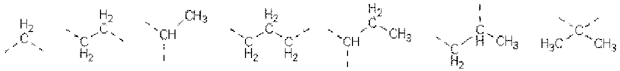

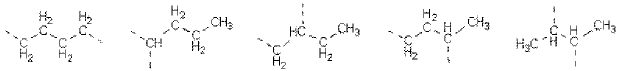

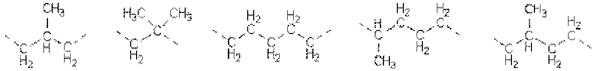

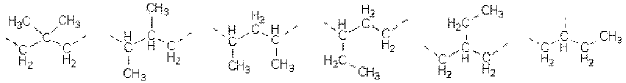

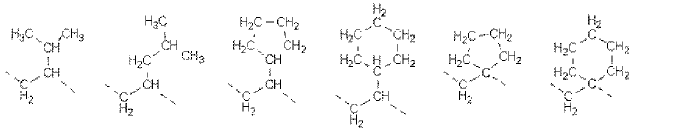

In the formulae, a dotted line represents an attachment point.

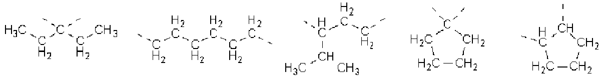

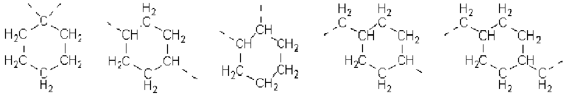

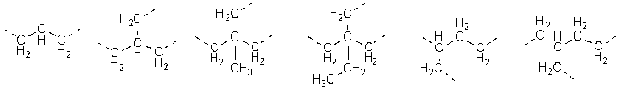

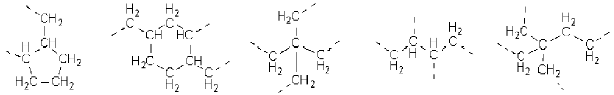

In the formulae, a dotted line represents an attachment point.

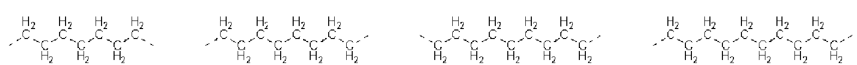

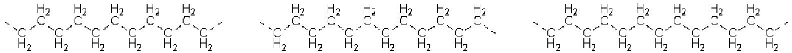

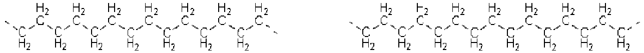

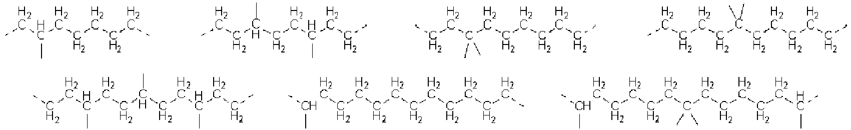

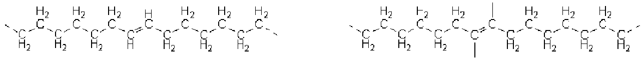

In the formulae, a dotted line represents an attachment point.

Examples of the linear, branched, or cyclic (ka+2)-valent fluorinated hydrocarbon group Az having 1 to 20 carbon atoms specifically include groups in which a part or all of the hydrogen atoms in the above hydrocarbon group are substituted with a fluorine atom. In addition, -CH₂- constituting the hydrocarbon group may be substituted with -O-, -C(=O)-, or -Si(R²R³)-. The number of carbon atoms in Az is preferably 2 to 18, more preferably 3 to 16, and further preferably 4 to 14. Some -CH₂- constituting the hydrocarbon group are preferably substituted with -Si(R²R³)- or -Si(R²R³)-O-.

Specific examples of the linear, branched, or cyclic alkyl groups R² and R³ having 1 to 6 carbon atoms include a methyl group, an ethyl group, a propyl group, an isopropyl group, an n-butyl group, a sec-butyl group, a tert-butyl group, an n-pentyl group, an n-hexyl group, a cyclopropyl group, a cyclobutyl group, a cyclopentyl group, and a cyclohexyl group.

Specific examples of the linear, branched, or cyclic monovalent hydrocarbon group Xf having 1 to 10 carbon atoms and optionally substituted with a fluorine atom include: alkyl groups, such as a methyl group, an ethyl group, a propyl group, an isopropyl group, an n-butyl group, a sec-butyl group, a tert-butyl group, a cyclopropyl group, and a cyclobutyl group; and a trifluoromethyl group and a 2,2,2-trifluoroethyl group.

Specific examples of the alkoxy group Xf having 1 to 10 carbon atoms and optionally substituted with a fluorine atom include a methoxy group, an ethoxy group, a propoxy group, an isopropoxy group, an n-butoxy group, a sec-butoxy group, a tert-butoxy group, a cyclopropoxy group, a trifluoromethoxy group, and a 2,2,2-trifluoroethoxy group.

Specific examples of the electron withdrawing group Xf include a carbonyl group, an alkoxycarbonyl group, a cyano group, a nitro group, a sulfo group, a formyl group, a sulfonate ester group, an amide group, and -O-C(=O)-G- (G represents a sulfur atom or NH).

Specific examples of the aromatic monocyclic or polycyclic ring ZZ having 3 to 20 carbon atoms include the following rings. As described below, the ring ZZ may further have a substituent.

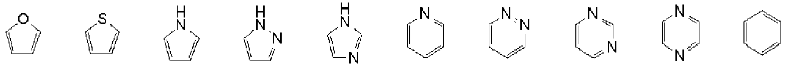

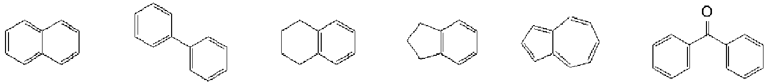

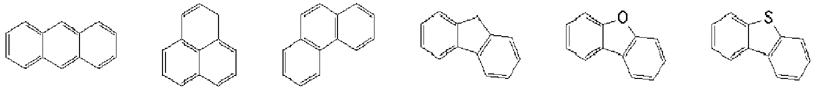

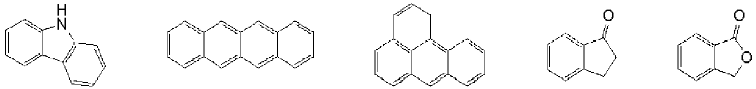

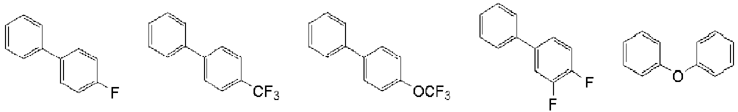

The phenol compound represented by the general formula (1A) is particularly preferably a phenol compound represented by the following general formula (1B) .

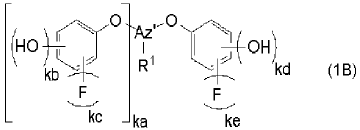

In the formula, Az' represents a linear, branched, or cyclic (ka+2)-valent hydrocarbon group or fluorinated hydrocarbon group having 1 to 19 carbon atoms, and -CH₂- constituting the hydrocarbon group is optionally substituted with -O-, -C(=O)-, or -Si(R²R³)-; ka represents 0 or 1; kb, kc, kd, and ke represent 1 or 2; and R¹, R², and R³ are same as above.

Specific examples of the compound represented by the general formulae (1A) and (1B) include the following compounds.

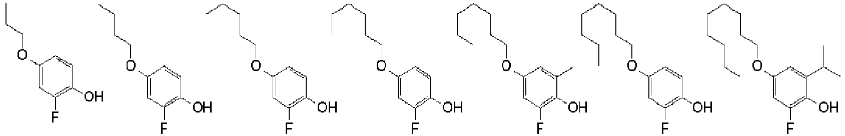

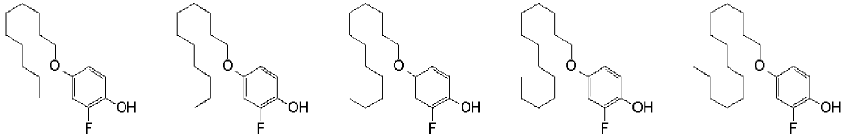

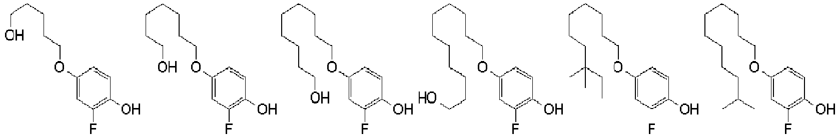

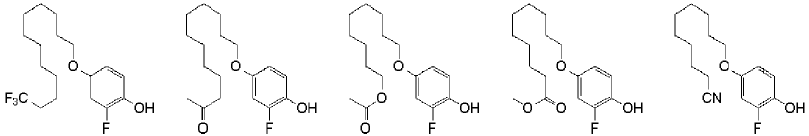

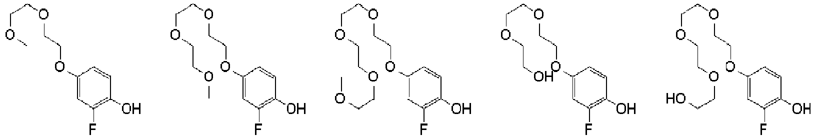

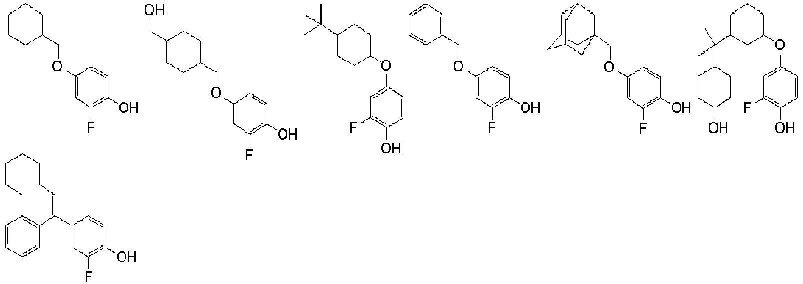

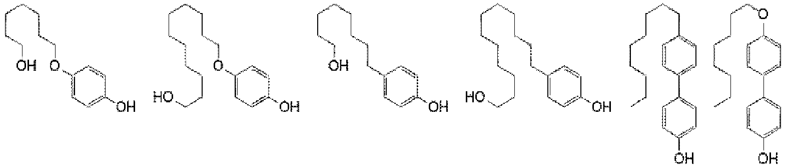

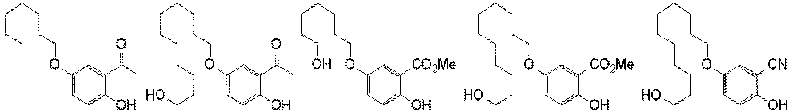

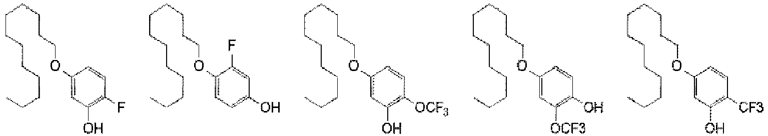

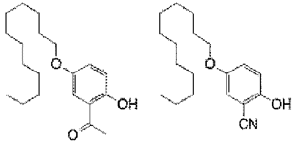

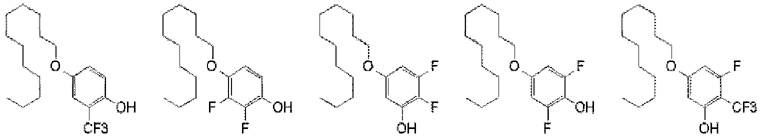

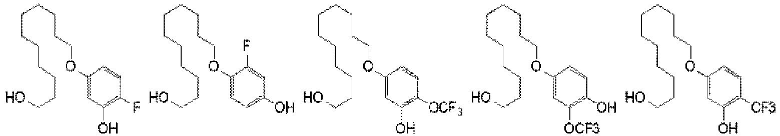

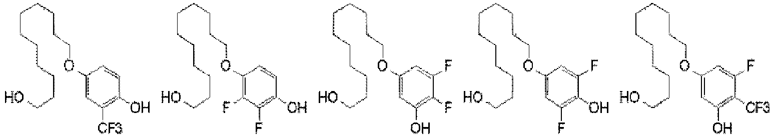

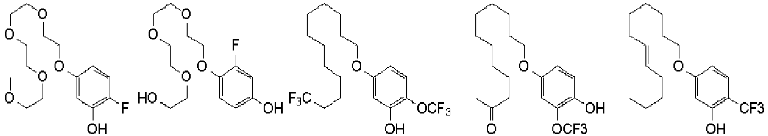

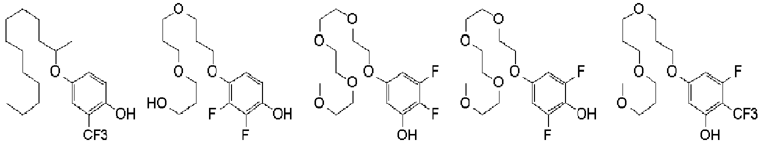

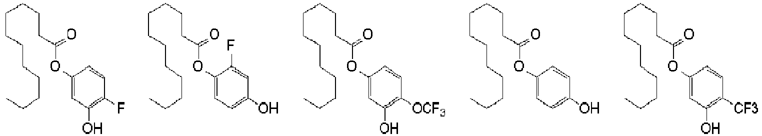

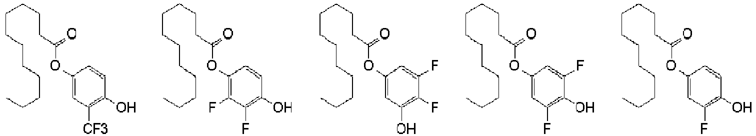

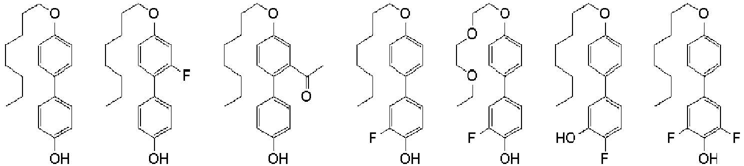

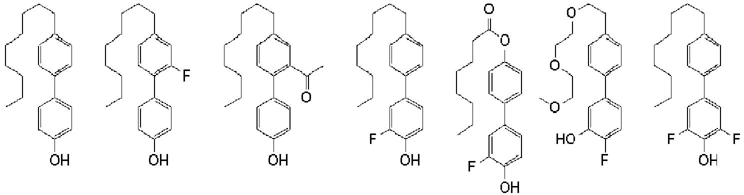

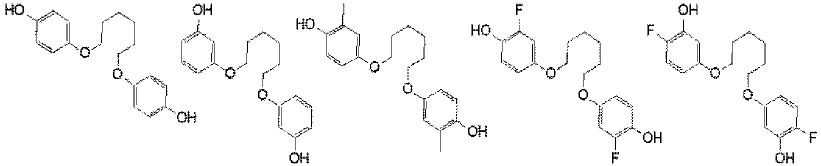

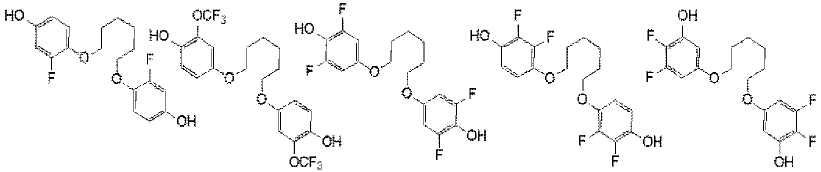

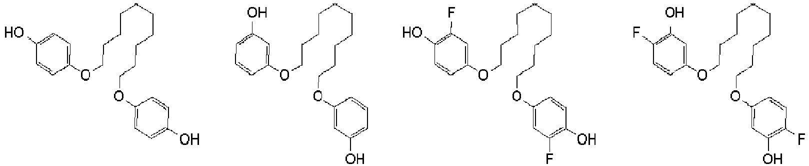

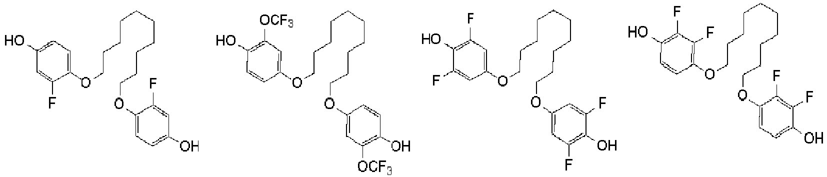

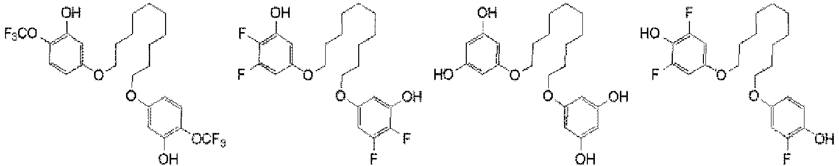

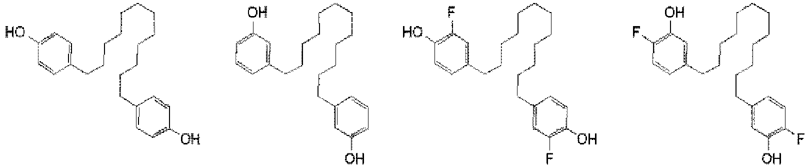

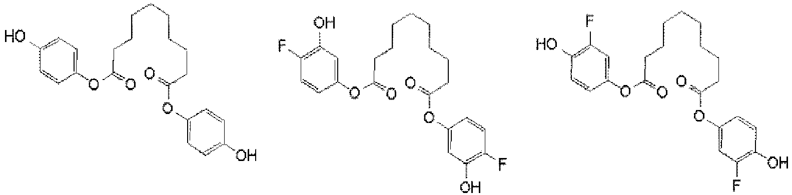

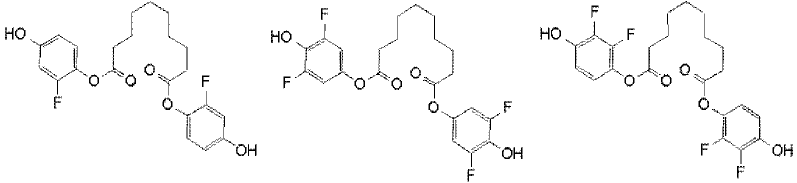

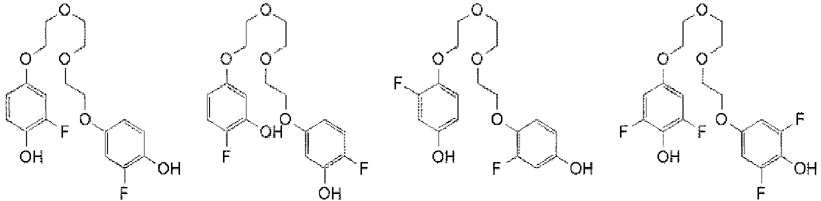

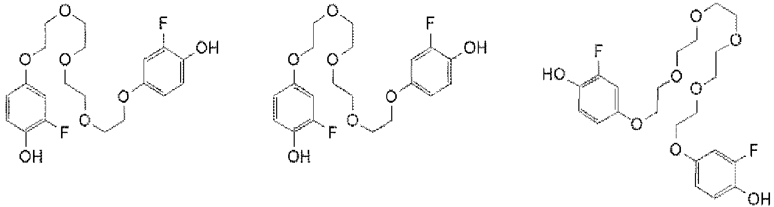

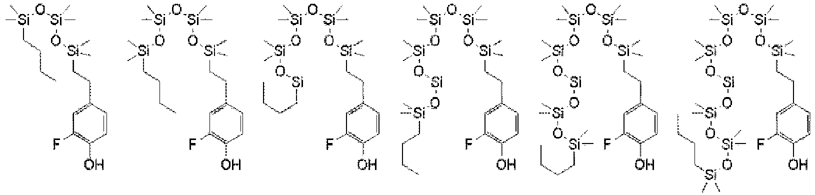

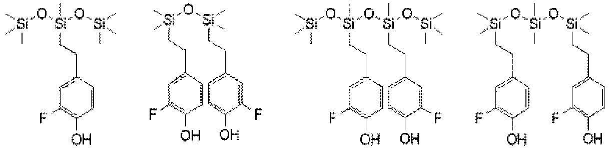

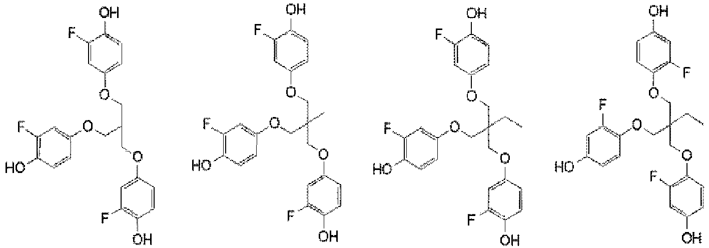

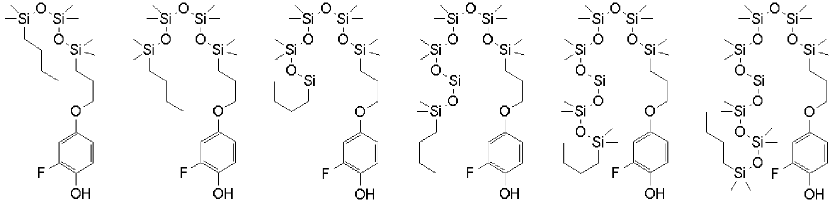

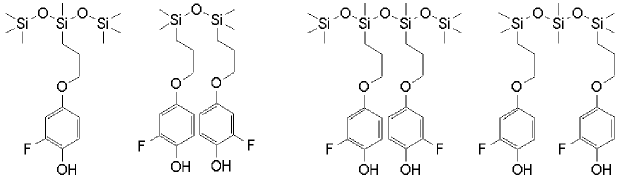

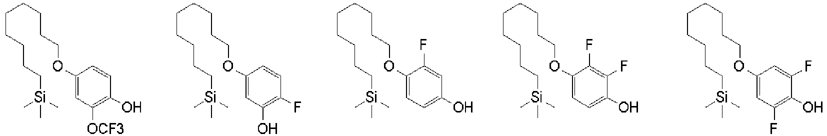

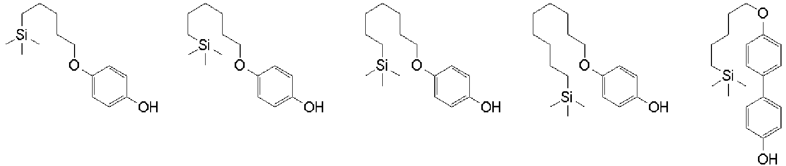

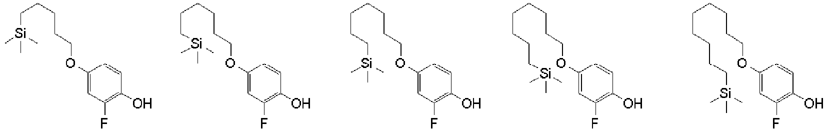

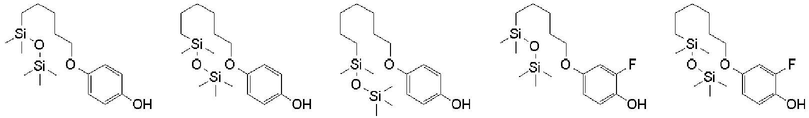

A blending amount of the component (B) is an amount to be 0.01 to 10 mass%, preferably 0.03 to 5 mass%, and more preferably 0.05 to 1.0 mass% relative to the entirety of the composition. If the blending amount is less than 0.01 mass%, the thermal conductive addition-curable silicone composition has a poor effect of contribution to improvement of the heat-dissipating ability. Even if the blending amount is more than 10 mass%, the effect of improving the heat-dissipating ability does not become remarkable, which is not economical and thus unpreferable.

### Component (C)

The component (C) is a silver powder. A method for manufacturing the silver powder is not particularly limited, and example thereof include an electrolysis method, a crushing method, a thermal treating method, an atomizing method, and a reduction method. The shape is not particularly limited, and may be flake, spherical, particle, amorphous, dendroid, needle, etc.

The component (C) having an average particle diameter of 0.01 um or more yields the composition having not excessively high viscosity and having excellent extensibility. The component (C) having an average particle diameter of 300 um or less yields the uniform composition. Therefore, the average particle diameter is preferably within a range of 0.01 to 300 µm, preferably within a range of 0.1 to 100 µm, and more preferably within a range of 1 to 50 um. The average particle diameter can be determined as, for example, a volume-based average value (or a median diameter) in particle size distribution measurement by a laser light diffraction method.

The component (C) may be used singly, or may be used in combination of two or more. The ratio may be any, and not particularly limited.

A blending amount of the component (C) is an amount to be 10 to 98 mass%, preferably 70 to 97 mass%, and more preferably 80 to 95 mass% relative to the entirety of the component. A blending amount of more than 98 mass% may cause the composition to have considerably increased viscosity to deteriorate operability. A blending amount of less than 10 mass% causes poor thermal conductivity.

### Component (D)

The component (D) is an organohydrogenpolysiloxane having two or more hydrogen atoms bonded to a silicon atom in one molecule, namely an organohydrogenpolysiloxane having 2 or more, particularly 2 to 100, and further preferably 2 to 50, hydrogen atoms bonded to a silicon atom (SiH groups) in one molecule. The organohydrogenpolysiloxane may be any as long as the SiH group in the molecule causes an addition reaction with the aliphatic unsaturated hydrocarbon group in the aforementioned component (A) in the presence of the platinum-group metal catalyst to form a crosslinked structure.

The molecular structure of the organohydrogenpolysiloxane is not particularly limited as long as the organohydrogenpolysiloxane has the above properties, and examples thereof include a linear structure, a branched structure, a cyclic structure, a partially branched structure, or a linear structure having a cyclic structure. The molecular shape is preferably a linear structure or a cyclic structure.

The organohydrogenpolysiloxane has a kinematic viscosity at 25°C of preferably 1 to 1,000 mm²/s and more preferably 10 to 300 mm²/s. The kinematic viscosity of 1 mm²/s or more causes no risk of deterioration of the physical properties of the thermal conductive addition-curable silicone composition. The kinematic viscosity of 1,000 mm²/s or less yields good extensibility of the thermal conductive addition-curable silicone composition.

Examples of an organic group bonded to a silicon atom of the organohydrogenpolysiloxane include an unsubstituted or substituted monovalent hydrocarbon group other than the aliphatic unsaturated hydrocarbon group. The organic group is specifically an unsubstituted or substituted monovalent hydrocarbon group having 1 to 12, preferably 1 to 10, carbon atoms. Examples thereof include: alkyl groups, such as a methyl group, an ethyl group, a propyl group, a butyl group, a hexyl group, and a dodecyl group; aryl groups, such as a phenyl group; aralkyl groups, such as a 2-phenylethyl group and a 2-phenylpropyl group; and groups in which a part or all of hydrogen atoms in these groups are substituted with a halogen atom such as fluorine, bromine, and chlorine, a cyano group, an epoxy-ring-containing organic group (a glycidyl-group or a glycidyloxy-group-substituted alkyl group), etc., for example, a chloromethyl group, a chloropropyl group, a bromoethyl group, a trifluoropropyl group, a cyanoethyl group, a 2-glycidoxyethyl group, a 3-glycidoxypropyl group, and a 4-glycidoxybutyl group. Among these, a methyl group and a trifluoropropyl group are preferable.

The organohydrogenpolysiloxane may be used singly, or two or more thereof may be mixed for use.

A blending amount of the organohydrogenpolysiloxane being the component (D) is an effective amount sufficient for the composition for forming the cured product, and preferably an amount such that a number of the SiH groups in the component (D) relative to a total number of the aliphatic unsaturated hydrocarbon group in the component (A) is preferably 0.5 to 10, more preferably 0.7 to 7.5, and further preferably 1.0 to 5.0. The amount of the component (D) of the lower limit or more sufficiently proceeds the addition reaction to yield sufficient crosslinking. The amount of the upper limit or less does not cause ununiform crosslinking structure and not deteriorate storability of the composition.

### Component (E)

The component (E) is a platinum-group metal catalyst, and functions to promote the addition reaction of the aforementioned components. As the platinum-group metal catalyst, conventionally known catalyst used for the addition reaction may be used. Examples thereof include platinum-based, palladium-based, and rhodium-based catalysts, and platinum or a platinum compound is easily available, and particularly preferable. Example thereof include platinum simple substance, platinum black, chloroplatinic acid, a platinum-olefin complex, a platinum-alcohol complex, and a platinum coordination compound. The platinum-group metal catalyst may be used singly, or may be used in combination of two or more.

A blending amount of the component (E) is an effective amount as the catalyst, namely an effective amount necessary for promoting the addition reaction to cure the thermal conductive addition-curable silicone composition of the present invention. The blending amount is preferably 0.1 to 500 ppm, more preferably 1 to 200 ppm, and further preferably 10 to 100 ppm on a mass basis in terms of the platinum-group metal atom in the entirety of the composition. The amount of the catalyst of the lower limit or more can yield the effect as the catalyst, and the amount of the upper limit or less yields a sufficient catalyst effect, which is economical.

Into the thermal conductive addition-curable silicone composition of the present invention, the following optional components may be added as necessary in addition to the above components.

### Component (F)

The component (F) is one or more addition-curing reaction controlling agents selected from the group consisting of an acetylene compound, a nitrogen compound, an organophosphorus compound, an oxime compound, and an organochlorine compound, which inhibit proceeding of the hydrosilylation reaction at room temperature. The component (F) may be added in order to extend the shelf-life and the pot-life. As the addition-curing reaction controlling agent, conventionally known addition-curing reaction controlling agents used for an addition-curable silicone composition may be used. Examples thereof include: acetylene compounds, such as acetylene alcohols (for example, ethynylmethyl decyl carbinol, 1-ethynyl-1-cyclohexanol, and 3,5-dimethyl-1-hexyn-3-ol); various nitrogen compounds, such as tributylamine, tetramethylethylenediamine, and benzotriazole; organophosphorus compounds, such as triphenylphosphine; oxime compounds; and organochlorine compounds.

When the component (F) is blended, the blending amount is an effective amount, and preferably 0.05 to 10 parts by mass, more preferably 0.07 to 5 parts by mass, and further preferably 0.1 to 2 parts by mass relative to 100 parts by mass of the component (A). The amount of the reaction controlling agent of 0.05 parts by mass or more can yield the desired sufficient shelf-life and pot-life. The amount of less than or equal to 10 parts by mass does not decrease curability of the silicone component.

The reaction controlling agent may be diluted with an organo(poly)siloxane, toluene, etc. for use in order to improve dispersibility into the silicone component.

### Other Components

The thermal conductive addition-curable silicone composition of the present invention may contain an organo(poly)siloxane having no reactivity such as methylpolysiloxane in order to regulate strength and viscosity of the composition. Further, one or more conventionally known thermal conductive fillers other than the silver may be used in combination. For a purpose of improving filling ability of the thermal conductive filler or a purpose of imparting adhesiveness to the composition, a hydrolysable organopolysiloxane, modified silicones, and a hydrolysable organosilane may be further blended. Further, a solvent for regulating the viscosity of the composition may be further blended. To prevent deterioration of the thermal conductive addition-curable silicone composition, a conventionally known oxidation inhibitor such as 2,6-di-tert-butyl-4-methylphenol may be further contained as necessary. A dye, a pigment, a flame retardant, a precipitation inhibitor, a thixotropic improver, etc. may be further blended as necessary.

### Step of Producing Thermal Conductive Addition-Curable Silicone Composition

A method for manufacturing the thermal conductive addition-curable silicone composition of the present invention will be described. The method for manufacturing the thermal conductive addition-curable silicone composition of the present invention is not particularly limited, but includes a step of producing the thermal conductive addition-curable silicone composition containing the aforementioned components (A) to (E), and the additional component (F) and other components as necessary.

Examples thereof include a method of mixing the aforementioned components (A) to (E), and as necessary the component (F) and other components by using a mixer such as, for example, Trimix, Twin Mix, and Planetary Mixer (all are registered trademarks of mixers manufactured by INOUE MFG., INC.), Ultra Mixer (a registered trademark of a mixer manufactured by MIZUHO INDUSTRIAL CO., LTD.), and HIVIS MIX (a registered trademark of a mixer manufactured by PRIMIX Corporation) at 25°C for typically 3 minutes to 24 hours, preferably 5 minutes to 12 hours, and particularly preferably 10 minutes to 6 hours. In the mixing, degassing may be performed, and the mixing may be performed while heating within a range of 40 to 170°C.

In the present invention, it is preferable that the components (A) and (C) are mixed in advance at 70°C, and then the components (B), (D), and (E) are mixed at 25°C from the viewpoint of exhibiting good thermal conductivity of the thermal conductive addition-curable silicone composition. When the component (F), which is an optional component, is blended, it is preferable that the component (A) and (C) are mixed in advance, then the component (F) is mixed, and then the components (B), (D), and (E) are mixed.

The thermal conductive addition-curable silicone composition of the present invention has a viscosity measured at 25°C of preferably 10 to 1,000 Pa·s, more preferably 20 to 700 Pa·s, and further preferably 40 to 600 Pa·s. The viscosity of 10 Pa·s or more causes no difficulty in shape retention, and does not deteriorate operability such as no precipitation of the silver powder. The viscosity of 1,000 Pa·s or less does not deteriorate operation such as no difficulty in discharging and applying. The viscosity can be achieved by regulating the blending amount of each of the aforementioned components. The viscosity can be measured at 25°C by using, for example, a Malcom viscosimeter (type PC-1T).

A cured product of the thermal conductive addition-curable silicone composition of the present invention typically has a thermal conductivity of 0.5 to 100 W/m·K, but preferably has a thermal conductivity of 7.0 W/m·K or more in order to exhibit excellent heat-dissipating performance when the cured product is mounted on an electronic component package or a power module.

Curing conditions for heating and curing the thermal conductive addition-curable silicone composition of the present invention is not particularly limited, and typically 80 to 200°C, preferably 100 to 180°C, for 15 minutes to 4 hours, preferably 30 minutes to 2 hours.

Specifically, the cured product of a thermal conductive addition-curable silicone of the present invention preferably has a thermal conductivity of 7.0 W/m·K or more, wherein the thermal conductivity is determined by:
sandwiching the aforementioned thermal conductive addition-curable silicone composition between two silicon plates having a diameter of 12.7 mm;
heating and curing the composition at 125°C for 1 hour in a state of applying a pressure of 0.14 MPa to produce a specimen for measuring thermal resistivity;
measuring a thermal resistivity value of the cured product of a thermal conductive addition-curable silicone by using a thermal conductivity measuring device;
measuring a thickness of the specimen with a micro-gauge;
calculating a thickness of the cured product of a thermal conductive addition-curable silicone with a difference from a thickness of the silicon plates measured in advance; and thereafter
deriving the thermal conductivity of the cured product of a thermal conductive addition-curable silicone by "the thickness (µm) of the cured product of a thermal conductive addition-curable silicone / the thermal resistivity value (mm²·K/W) of the cured product of a thermal conductive addition-curable silicone".

### EXAMPLE

Hereinafter, the present invention will be described in more detail with showing Examples and Comparative Examples, but the present invention is not limited to the following Examples. A kinematic viscosity refers to a value at 25°C with an Ubbelohde-type Ostwald viscometer.

First, the following components for preparing the thermal conductive addition-curable silicone composition of the present invention were prepared.

### Component (A)

A-1: Dimethylpolysiloxane having both terminals blocked with a dimethylvinylsilyl group and having a kinematic viscosity at 25°C of 600 mm²/s
A-2: Dimethylpolysiloxane having both terminals blocked with a dimethylvinylsilyl group and having a kinematic viscosity at 25°C of 30,000 mm²/s
A-3: Organopolysiloxane represented by the following formula (2) and having a kinematic viscosity at 25°C of 800 mm²/s

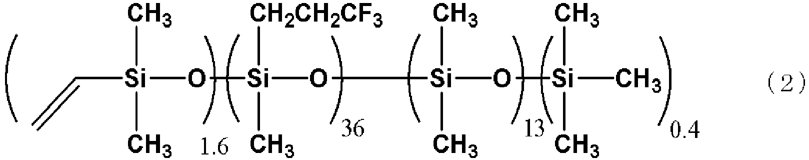

### Component (B)

### B-1: Phenol compound represented by the following formula (3)

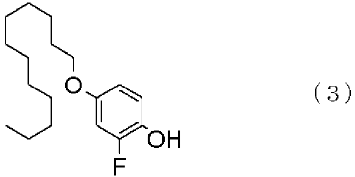

### B-2: Phenol compound represented by the following formula (4)

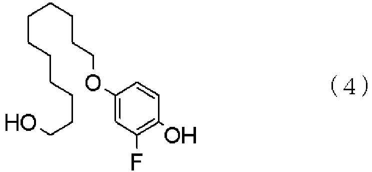

### B-3: Phenol compound represented by the following formula (5)

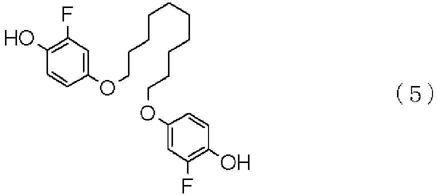

### B-4: Phenol compound represented by the following formula (6)

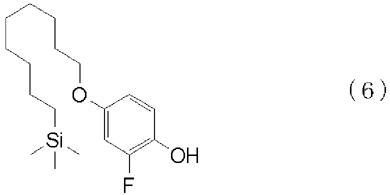

### B-5: Phenol compound represented by the following formula (7)

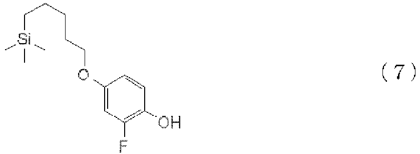

### Component (C)

C-1: Flake silver powder having an average particle diameter of 15 µm, a tap density of 4.0 g/mL, and a specific surface area of 0.5 m²/g
C-2: Flake silver powder having an average particle diameter of 4 µm, a tap density of 2.2 g/mL, and a specific surface area of 2.0 m²/g
C-3: Flake silver powder having an average particle diameter of 4 µm, a tap density of 2.3 g/mL, and a specific surface area of 0.9 m²/g
C-4: Flake silver powder having an average particle diameter of 2 µm, a tap density of 2.4 g/mL, and a specific surface area of 0.9 m²/g
C-5: Spherical silver powder having an average particle diameter of 3 µm, a tap density of 6.9 g/mL, and a specific surface area of 0.2 m²/g

### Component (D)

D-1: Methylhydrogendimethylpolysiloxane represented by the following formula (8)
   (kinematic viscosity at 25°C = 100 mm²/s) 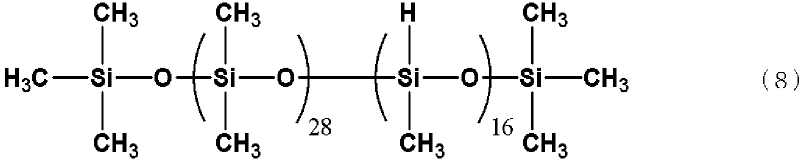
D-2: Methylhydrogentrifluoropropylmethylpolysiloxane represented by the following formula (9)
   (kinematic viscosity at 25°C = 60 mm²/s)

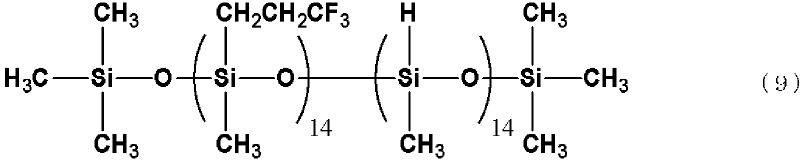

### Component (E)

E-1: Solution in which a platinum-divinyltetramethyldisiloxane complex is dissolved in the dimethylpolysiloxane same as the A-1 (platinum atom content: 1 mass%)
E-2: Solution in which a platinum-divinyltetramethyldisiloxane complex is dissolved in ethanol (platinum atom content: 3 mass%)

### Component (F)

F-1: 1-Ethynyl-1-cyclohexanol represented by the following formula (10)

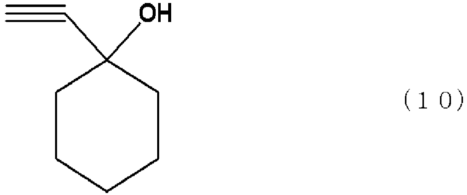

### Examples 1 to 17 and Comparative Examples 1 to 7

### Preparation of Thermal Conductive Addition-Curable Silicone Composition

The above components (A) to (F) were blended at blending amounts shown in the following Tables 1 to 4 by the following method to prepare thermal conductive addition-curable silicone compositions. In Tables, "SiH/SiVi" refers to a ratio of a number of SiH groups in the component (D) relative to a total number of alkenyl groups in the component (A).

In a 0.3-L HIVIS MIX (manufactured by PRIMIX Corporation), the components (A) and (C) were added, and the mixture was mixed at 70°C for 1 hour. This mixture was cooled to 40°C or lower, then the components (F), (E), (D), and (B) were added, and the mixture was mixed for uniformization to prepare the composition.

A viscosity and a thermal conductivity of each of the thermal conductive addition-curable silicone compositions obtained by the above method were measured according to the following methods. Tables 1 to 4 show the results.

### Viscosity

An absolute viscosity of each of the thermal conductive addition-curable silicone compositions was measured at 25°C by using a Malcom viscosimeter (type PC-1T) (with rotor A at 10 rpm, shear rate: 6 [1/s]).

### Thermal Conductivity

Each of the thermal conductive addition-curable silicone compositions was sandwiched between two silicon plates having a diameter of 12.7 mm, the composition was heated and cured at 125°C for 1 hour in a state of applying a pressure of 0.14 MPa to produce a specimen for measuring thermal resistivity, and a thermal resistivity value of the cured product of a thermal conductive addition-curable silicone was measured. Further, a thickness of the specimen was measured with a micro-gauge, and a thickness of the cured product of a thermal conductive addition-curable silicone was calculated with a difference from a thickness of the silicon plates measured in advance. Thereafter, the thermal conductivity of the cured product of a thermal conductive addition-curable silicone was derived by the following formula. (the thickness (µm) of the cured product of a thermal conductive addition-curable silicone) / (the thermal resistivity value (mm2·K/W) of the cured product of a thermal conductive addition-curable silicone)

Note that the thermal resistivity was measured by using Nanoflash (LFA447, manufactured by NETZSCH Japan K.K.) .

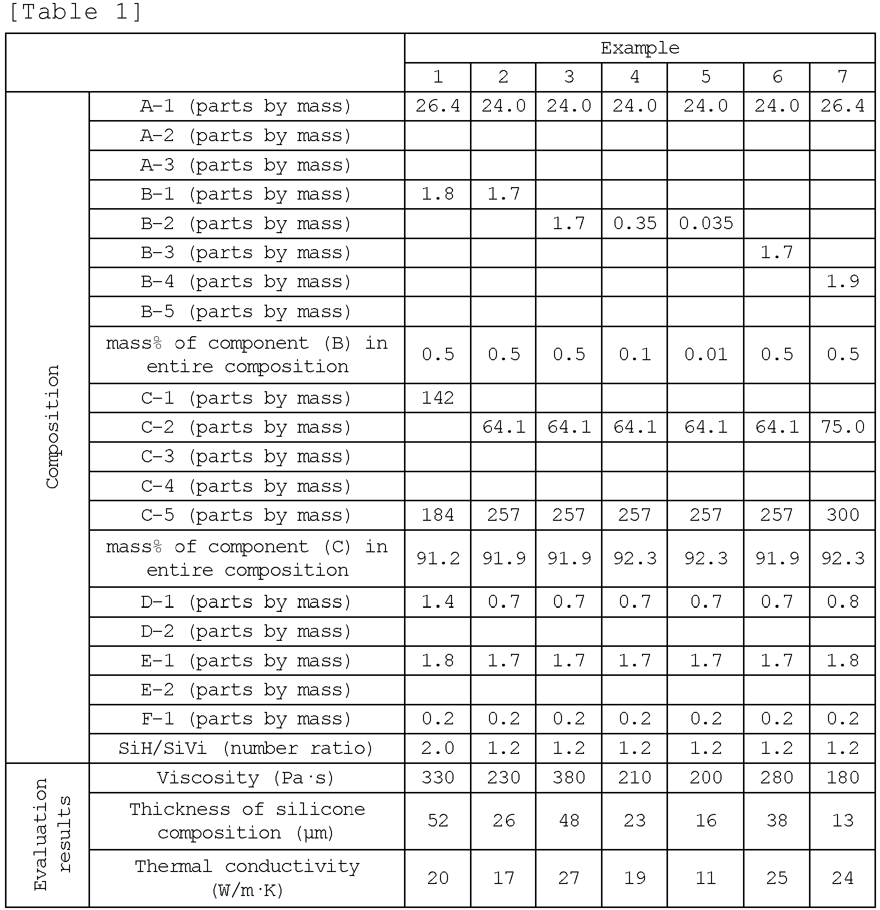

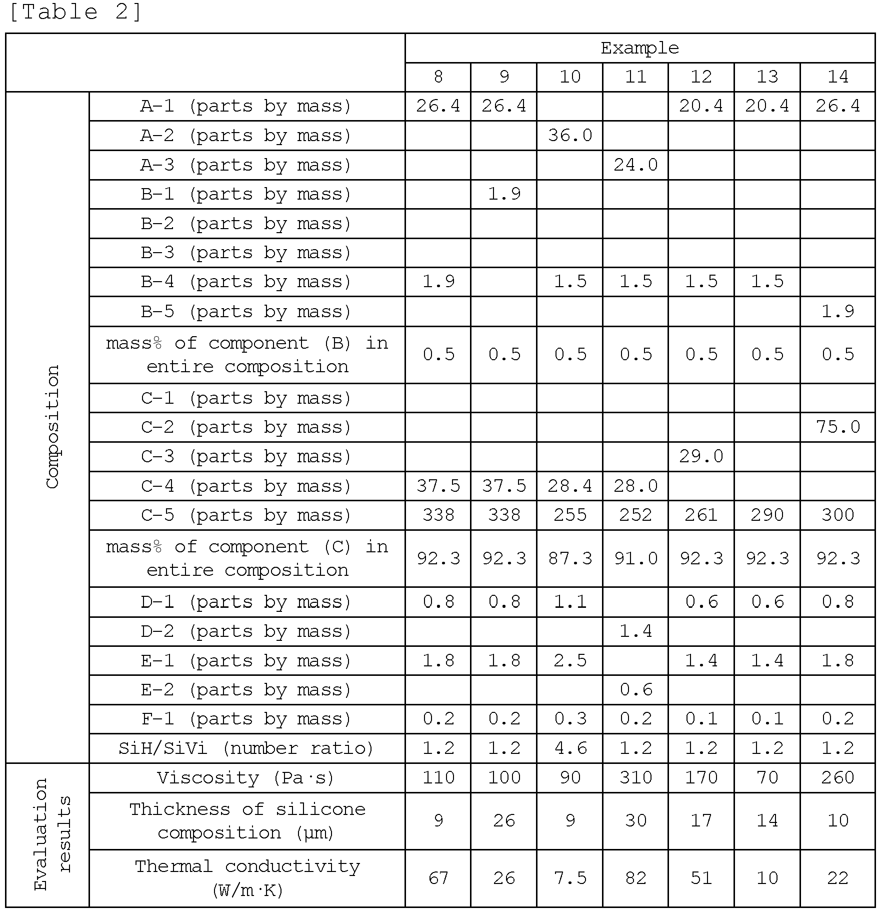

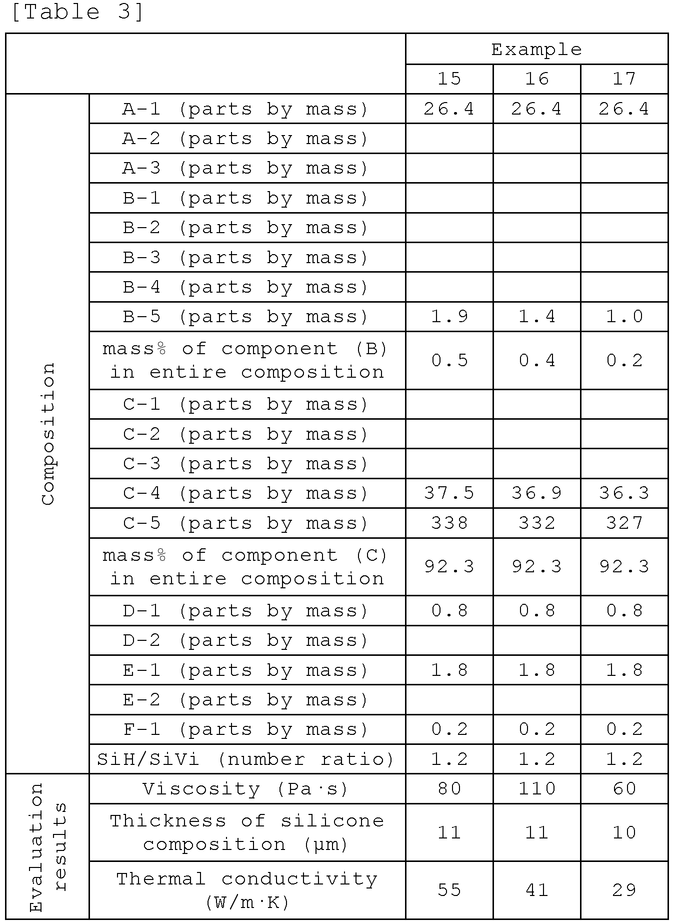

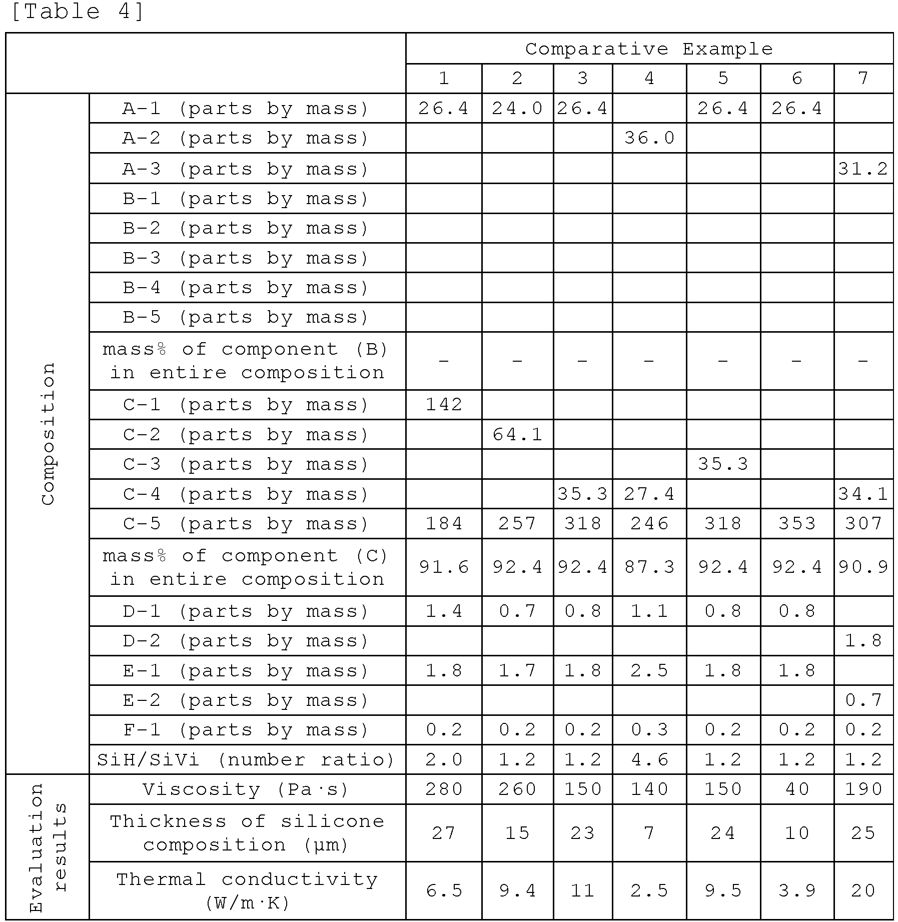

From the results in Tables 1 to 4, it is found that the cured products of the thermal conductive addition-curable silicone compositions of Examples 1 to 17, which satisfy the requirements of the present invention, have remarkably improved thermal conductivity by adding the phenol compound of the component (B) compared with the corresponding cured products of the thermal conductive addition-curable silicone composition of Comparative Examples 1 to 7, which do not contain the phenol compound of the component (B).

Therefore, the thermal conductive addition-curable silicone composition of the present invention has achieved increase in thermal conductivity by blending the phenol compound and the silver powder. As a result, mounting the composition on an electronic package or a power module can exhibit excellent heat-dissipating performance.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A thermal conductive addition-curable silicone composition, comprising:
an organopolysiloxane (A) having at least one aliphatic unsaturated hydrocarbon group in one molecule and having a kinematic viscosity at 25°C of 60 to 100,000 mm²/s;
a phenol compound (B) at an amount of 0.01 to 10 mass% relative to an entirety of the composition;
a silver powder (C) at an amount of 10 to 98 mass% relative to the entirety of the composition;
an organohydrogenpolysiloxane (D) having two or more hydrogen atoms bonded to a silicon atom in one molecule at an effective amount sufficient for the composition to form a cured product; and
a platinum-group metal catalyst (E) at an effective amount.

2. The thermal conductive addition-curable silicone composition according to claim 1, wherein the component (B) is a phenol compound represented by the following general formula (1A), 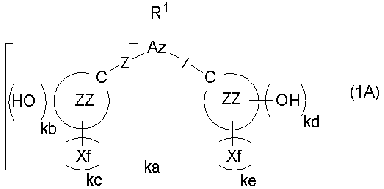 wherein R¹ represents a hydrogen atom, a halogen atom, a cyano group, or a hydroxy group; Az represents a linear, branched, or cyclic (ka+2)-valent hydrocarbon group or fluorinated hydrocarbon group having 1 to 20 carbon atoms, -CH₂- constituting the hydrocarbon group is optionally substituted with -O-, -C(=O)-, or - Si(R²R³)-, and R² and R³ represent a linear, branched, or cyclic alkyl group having 1 to 6 carbon atoms or a phenyl group; Xf each independently represents a hydrogen atom, a halogen atom, a linear, branched or cyclic monovalent hydrocarbon group having 1 to 10 carbon atoms and optionally substituted with a fluorine atom, an alkoxy group having 1 to 10 carbon atoms and optionally substituted with a fluorine atom, or an electron withdrawing group; Z represents a single bond or an oxygen atom; a ring ZZ each independently represents an aromatic monocyclic or polycyclic ring having 3 to 20 carbon atoms, and a carbon atom in the ring ZZ is optionally substituted with a nitrogen atom, an oxygen atom, or a sulfur atom; ka represents an integer of 0 to 2; kb and kd represent 1 or 2; and kc and ke represent an integer of 0 to 2.

3. The thermal conductive addition-curable silicone composition according to claim 2, wherein the component (B) is a phenol compound represented by the following general formula (1B), 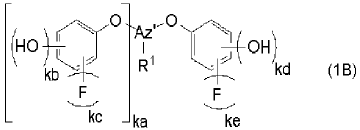 wherein Az' represents a linear, branched, or cyclic (ka+2)-valent hydrocarbon group or fluorinated hydrocarbon group having 1 to 19 carbon atoms, and -CH₂- constituting the hydrocarbon group is optionally substituted with -O-, -C(=O)-, or -Si(R²R³)-; ka represents 0 or 1; kb, kc, kd, and ke represent 1 or 2; and R¹, R², and R³ are same as above.

4. The thermal conductive addition-curable silicone composition according to any one of claims 1 to 3, wherein the component (C) has an average particle diameter of 0.01 to 300 µm.

5. The thermal conductive addition-curable silicone composition according to any one of claims 1 to 4, further comprising an effective amount of one or more addition-curing reaction controlling agents (F) selected from the group consisting of an acetylene compound, a nitrogen compound, an organophosphorus compound, an oxime compound, and an organochlorine compound.

6. A cured product of a thermal conductive addition-curable silicone having a thermal conductivity of 7.0 W/m·K or more, wherein the thermal conductivity is determined by:
sandwiching the thermal conductive addition-curable silicone composition according to any one of claims 1 to 5 between two silicon plates having a diameter of 12.7 mm;
heating and curing the composition at 125°C for 1 hour in a state of applying a pressure of 0.14 MPa to produce a specimen for measuring thermal resistivity;
measuring a thermal resistivity value of the cured product of a thermal conductive addition-curable silicone by using a thermal conductivity measuring device;
measuring a thickness of the specimen with a micro-gauge;
calculating a thickness of the cured product of a thermal conductive addition-curable silicone with a difference from a thickness of the silicon plates measured in advance; and thereafter
deriving the thermal conductivity of the cured product of a thermal conductive addition-curable silicone by "the thickness (µm) of the cured product of a thermal conductive addition-curable silicone / the thermal resistivity value (mm²·K/W) of the cured product of a thermal conductive addition-curable silicone".
